# FASCICULE DE BREVET EUROPEEN

(11) **EP 2 556 549 B1**
(45) Date de publication et mention de la délivrance du brevet: **24.07.2019**
(21) Numéro de dépôt: 11717769.1
(22) Date de dépôt: 04.04.2011
(51) Int. Cl.: H01L 51/50

(54) **Diode électroluminescente organique comportant au moins deux couches électroluminescentes**
Organische Leuchtdiode mit mindestens zwei elektrolumineszenten Schichten
Organic light-emitting diode comprising at least two electroluminescent layers

(30) Priorité: 06.04.2010 FR 1001423
(43) Date de publication de la demande: 13.02.2013
(73) Titulaire: Commissariat à l'Énergie Atomique et aux Énergies Alternatives, 75015 Paris (FR)
(72) Inventeur: VAUFREY, David, F-38000 Grenoble (FR); SERMET, Frédéric, F-38430 Saint Jean De Moirans (FR)
(74) Mandataire: Gevers & Orès
(86) Numéro de dépôt international: PCT/IB2011/051438
(87) Numéro de publication internationale: WO 2011/125018

(56) Documents cités:
- EP-A1- 1 784 056
- EP-A1- 1 936 714
- DE-A1-102007 058 005
- JP-A- 2007 189 002
- US-A1- 2002 027 416
- US-A1- 2009 001 875
- US-A1- 2009 091 250
- YAMADA T ET AL: "Revealing bipolar charge-transport property of 4,4'-N,N'-dicarbazolylbiphenyl (CBP) by quantum chemical calculations", ORGANIC ELECTRONICS, ELSEVIER, AMSTERDAM, NL, vol. 12, no. 1, 1 January 2011 (2011-01-01), pages 169-178, XP027577002, ISSN: 1566-1199 [retrieved on 2010-12-27]
- JI GEUN JANG ET AL: "Blue Phosphorescent Organic Light-Emitting Devices with the Emissive Layer of mCP:FCNIr(pic)", ADVANCES IN MATERIALS SCIENCE AND ENGINEERING, vol. 17, article 445, 1 January 2012 (2012-01-01), pages 1-5, XP055325451, ISSN: 1687-8434, DOI: 10.1155/2012/192731

## Description

L'invention porte sur une diode électroluminescente organique comportant au moins deux couches électroluminescentes, et notamment sur une telle diode émettant une lumière blanche, comme décrite dans la revendication 1.

La couleur blanche est définie par la Commission Internationale de L'Eclairage.

Les diodes électroluminescentes organiques (aussi connues sous l'acronyme anglais « OLED », pour « Organic Light Emitting Diodes ») sont des composants optoélectroniques en développement rapide.

Alors qu'une diode électroluminescente « classique » est constituée de matériaux semi-conducteurs inorganiques, une OLED est constituée d'un empilement de couches de matériaux organiques, parmi lesquelles se trouve au moins une couche électroluminescente, fluorescente ou phosphorescente. Il en résulte une technologie de fabrication beaucoup plus simple et moins couteuse à mettre en oeuvre.

Les OLED émettant une lumière blanche peuvent trouver application dans l'éclairage domestique et dans le rétro-éclairage d'écrans plats (à cristaux liquides ou filtrés).

Pour générer une lumière blanche il est nécessaire de combiner au moins deux émetteurs de couleurs différentes. Par conséquent, les OLED blanches comprennent au moins deux couches électroluminescentes distinctes, présentant deux longueurs d'onde d'émission différentes, ou bien une seule couche contenant un mélange de deux matériaux électroluminescents présentant également deux longueurs d'onde d'émission différentes.

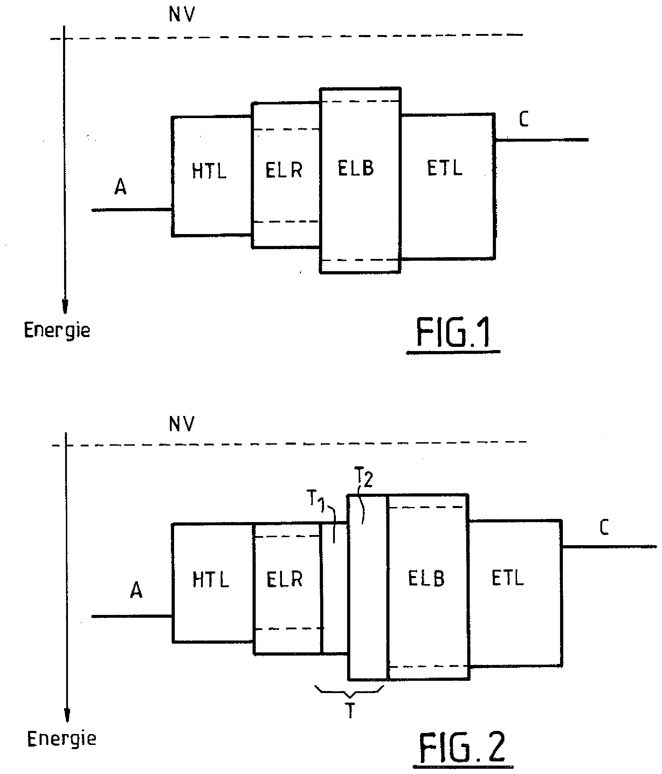

La figure 1 montre un diagramme de bandes plates d'une OLED blanche à deux émetteurs fluorescents spatialement séparés. De la gauche vers la droite on peut distinguer une anode A, une couche de transport des trous HTL, une couche électroluminescente rouge ELR, une couche électroluminescente bleue ELB, une couche de transport d'électrons ETL et une cathode C. Les rectangles représentent les bandes interdites des différents matériaux, comprises entre les niveaux HOMO (« highest occupied molecular orbital », c'est à dire orbital moléculaire occupé le plus haut) et LUMO (« lowest unoccupied molecular orbital », c'est à dire orbital moléculaire non occupé le plus bas). Les couches électroluminescentes se composent d'une matrice et d'un dopant fluorescent ; les lignes pointillées représentent les niveaux HOMO et LUMO des dopants, les lignes continues ceux des matrices. La référence NV indique le niveau du vide.

Les coordonnées chromatiques des deux émetteurs doivent se situer, dans un diagramme CIE1931, sur deux points reliés par un segment traversant la région dudit diagramme correspondant au blanc (dans le cas de trois émetteurs ou plus : le polygone obtenu en reliant les points représentant les couleurs d'émission des émetteurs doit contenir au moins une portion de la région blanche du diagramme CIE1931).

Cependant, le spectre d'émission d'une source de lumière blanche devant être utilisée comme éclairage n'est pas caractérisé de manière satisfaisante par les seules coordonnées du point correspondant dans l'espace chromatique CIE1931. Il faut également tenir compte d'un paramètre connu comme index de rendu de couleurs (CRI, de l'anglais « Color Rendering Index). Un CRI satisfaisant exige la formation du blanc à partir d'émetteurs dont les points représentatifs dans le diagramme CIE1931 sont très éloignés. En particulier, au moins un de ces émetteurs doit générer une lumière présentant une couleur très saturée. Généralement, il s'agit de l'émetteur bleu, ce qui permet de minimiser sa proportion de luminance tout en assurant une émission présentant les coordonnées chromatiques voulues. Ce choix permet de limiter le stress électrique imposé aux émetteurs organiques bleus, qui présentent une durée de vie moindre que ceux émettant de la lumière de plus grande longueur d'onde et constituent ainsi le facteur qui limite la durée de vie des OLED blanches. Cependant il faut aussi considérer que, pour un même niveau de luminance, la durée de vie des émetteurs bleus est d'autant plus faible que leur bande interdite est large - et donc qu'ils émettent une lumière d'une couleur bleue saturée. Par conséquent il est nécessaire de trouver un compromis, pas toujours satisfaisant, entre CRI et durée de vie.

Par émetteurs « bleus » ou « à bande interdite large » on entend des matériaux électroluminescents présentant une bande interdite comprise, à titre indicatif, entre 2,48 et 3,26 eV, ce qui correspond à des longueurs d'onde d'émission comprises entre 380 et 500 nm. D'une manière connue en soi, ces matériaux sont généralement constitués d'une matrice (ou matériau hôte) non luminescente contenant un dopant fluorescent ou phosphorescent. Lorsqu'on parle de la bande interdite d'un émetteur, on se réfère au dopant ; la bande interdite de la matrice est légèrement plus large.

La durée de vie d'un matériau organique à large bande interdite est limitée par plusieurs phénomènes physiques et physico-chimiques.

Premièrement, ces matériaux s'oxydent facilement de par leur niveau LUMO proche du niveau de vide.

Deuxièmement, de nombreux émetteurs bleus sont stables sous une forme ionique et se dégradent rapidement sous la forme ionique de signe opposé. Ainsi, ces matériaux doivent être utilisés pour conduire principalement des électrons (cas de la figure 1), ou principalement des trous ; la présence de porteurs minoritaires ou d'excitons (ce qui est nécessaire pour produire une émission de lumière) provoque une dégradation de nature électrochimique.

Troisièmement, on sait de manière empirique que ces matériaux conduisent relativement mal les porteurs, et subissent donc un stress électrique important.

Ces phénomènes, qui conduisent d'abord à une diminution progressive de la luminance au cours du temps, puis à une défaillance de la diode, se produisent également lorsque des émetteurs bleus sont utilisés seuls (dans des OLED bleues), mais dans ce cas il est possible de les compenser, au moins jusqu'à un certain point, par une augmentation progressive de la tension d'alimentation. Par contre, en cas d'association intime de deux ou plusieurs émetteurs, la différence de leurs durées de vie provoque une modification progressive et difficilement compensable du point couleur, c'est à dire des coordonnées chromatiques de la lumière émise.

En outre, en cas d'association intime de deux ou plusieurs émetteurs, les excitons générés dans l'émetteur de grande bande interdite ELB ont tendance à diffuser vers l'émetteur de plus petite bande interdite ELR, réduisant la luminance de l'émetteur bleu ELB, qui doit donc être soumis à un stress électrique plus élevé.

Ces problèmes ne sont pas uniquement propres aux OLED blanches, mais affectent toutes les OLED comprenant un émetteur bleu associé à un émetteur de bande interdite moins large.

Il est connu de séparer les couches électroluminescentes d'une OLED blanche (plus généralement, à deux émetteurs ou plus) par une couche de blocage d'électrons et/ou de trous destinée afin de contrôler le point couleur en modifiant la répartition des porteurs dans le dispositif. Une couche de blocage se définit par un niveau LUMO (HOMO) moins (plus) énergétique que le niveau LUMO (HOMO) de la couche adjacente du coté de la cathode (l'anode) s'il s'agit d'une couche de blocage d'électron (de trous). Une hauteur de barrière ou différence de niveau électronique est considérée comme ayant un effet bloquant dès lors qu'elle est supérieure à 0,3eV. Cette solution est décrite dans l'article de C.H. Kim et J. Shinar « Bright small molecular white organic light-emitting devices with two emission zones » Appl. Phys. Lett., Vol 80, N°12 (2002) pp 2201-2203. Elle présente l'inconvénient de réduire la conductivité de la diode, car justement la couche de blocage constitue une barrière au transport des porteurs. Par conséquent, à luminance égale, une différence de potentiel plus élevée doit être appliquée aux bornes de l'OLED, ce qui limite le gain en termes de durée de vie.

Il est également connu de l'art antérieur de former la couche émettrice en deux sous-couches adjacentes de matériaux hôtes distincts et dopés par le même dopant électroluminescent, l'ensemble étant nommé D-EML pour Double Emissive Layer (M. Ben Khalifa et al. « Efficient red phosphorescent organic light emitting diodes with double emission layers », J. Phys. D : Appl. Phys. 41 (2008) 155111). Cette jonction organique présente l'avantage d'associer un hôte conducteur de trous coté anode et un hôte conducteur d'électrons coté cathode. Ainsi la zone de recombinaison des porteurs se situe à cette jonction, et limite la diffusion des excitons vers des couches adjacentes externes à la D-EML. Cependant, il est très difficile, voir impossible, d'appliquer cette solution au cas d'une diode associant deux émetteurs ou plus, car cela requiert d'augmenter considérablement le nombre de couches évaporées (4 pour deux émetteurs et 6 pour trois), et d'autre part car les sous-couches en contact des deux ou trois D-EML doivent assurer une conductivité non négligeable à la fois pour les trous et les électrons.

Il est également connu de l'art antérieur d'introduire une couche de blocage excitonique dès lors que l'on associe dans une même diode des émetteurs fluorescent et phosphorescent. Voir l'article de Sung Hyun Kim, Jyongsik Jang et Jun Yeob Lee « High efficiency phosphorescent organic light-emitting diodes using carbazole-type triplet exciton blocking layer » Applied Physics Letters 90, 223505, 2007. Les émetteurs phosphorescents, en effet, sont intéressants pour les applications à basse luminance, où ils présentent des rendements très élevés. Mais comme il n'existe pas actuellement d'émetteur phosphorescent à large bande interdite présentant un temps de vie suffisant, il n'est pas possible de réaliser une diode électroluminescente blanche entièrement phosphorescente. D'où l'intérêt d'une association émetteur fluorescent bleu / émetteur phosphorescente à plus grande longueur d'onde. Cependant, si on ne prenait pas la précaution de séparer l'émetteur phosphorescent et l'émetteur fluorescent par une couche de blocage excitonique et on juxtaposait directement ces deux émetteurs, les excitons triplets du matériau phosphorescent pourraient diffuser vers le matériau fluorescent, où ils se désexciteraient de manière non radiative. Une couche de blocage excitonique présente typiquement une épaisseur de 3 - 10 nm, et un niveau LUMO (HOMO) inférieur (supérieur) à celui du dopant de l'émetteur phosphorescent. La couche de blocage excitonique réduit, elle-aussi, la conductivité de l'OLED, rendant nécessaire l'utilisation d'une tension de fonctionnement élevée qui a un effet défavorable sur la durée de vie des émetteurs.

Les documents EP 1 784 056 et EP 1 936 714 divulguent des OLED présentant une pluralité de couches électroluminescentes séparées par des couches intermédiaires de blocage excitonique. Les couches électroluminescentes sont constituées d'un même matériau-hôte contenant différents dopants ; les couches intermédiaires sont constituées par ce même matériau-hôte, mais sans dopage. Comme expliqué plus haut, les couches de blocage excitonique réduisent la conductivité de l'OLED ce qui a un effet défavorable sur la durée de vie des émetteurs.

Le document US 2009/0001875 divulgue des OLED comportant deux couches électroluminescentes séparées par une couches intermédiaire conductrice de trous. Encore une fois, une telle configuration ne peut que réduire la conductivité de l'OLED, et par conséquent la durée de vie de ses émetteurs.

Les documents DE 10 2007 058005 et US 2010/0314648 divulguent des OLED présentant trois couches électroluminescentes séparées par deux couches-tampon, ces dernières étant constituées par un mélange d'un matériau transporteur d'électrons et d'un matériau transporteur de trous.

Les documents US 2009/0091250 A1, US 2002/0027416 et JP 2007-189002 A décrivent également des OLED avec plusieurs couches électroluminescentes séparées par des couches transporteur de charges.

L'invention vise à surmonter les inconvénients de l'art antérieur pour augmenter la durée de vie des OLED comportant au moins deux couches électroluminescentes d'un même type émettant à des longueurs d'onde différentes.

Conformément à l'invention, ce but est atteint par une diode électroluminescente organique comprenant au moins deux couches électroluminescentes, toutes deux de type fluorescent ou de type phosphorescent et émettant à deux longueurs d'onde différentes, ainsi qu'une couche tampon conductrice d'électrons et de trous disposée entre lesdites couches électroluminescentes, et ladite couche tampon est une bicouche comportant une couche de transport d'électrons et une couche de transport de trous, comme décrit dans la revendication 1.

De préférence, ladite couche tampon peut conduire, sur au moins une partie de son épaisseur, tant les électrons que les trous.

Avantageusement, lesdites couches électroluminescentes peuvent comprendre une matrice et un dopant électroluminescent, et les deux couches de ladite bicouche peuvent comprendre une matrice de même composition que celle de la couche électroluminescente la plus proche.

Lesdites couches électroluminescentes comprennent une matrice et un dopant électroluminescent, et ladite couche tampon est uniquement constituée du ou des matériaux des matrices desdites couches électroluminescentes, et étant sans dopant.

Ladite couche tampon peut présenter une épaisseur comprise entre 1 et 10 nm.

L'une desdites couches électroluminescentes peut être adaptée pour émettre une lumière bleu. Plus particulièrement, lesdites couches électroluminescentes peuvent être choisies de manière à permettre l'émission de lumière blanche par la diode.

D'autres caractéristiques, détails et avantages de l'invention ressortiront à la lecture de la description faite en référence aux dessins annexés donnés à titre d'exemple et qui représentent, respectivement :
- La figure 1, un diagramme de bandes plates d'une OLED blanche selon l'art antérieur ;
- La figure 2, un diagramme de bandes plates d'une OLED blanche selon un mode de réalisation de l'invention ; et

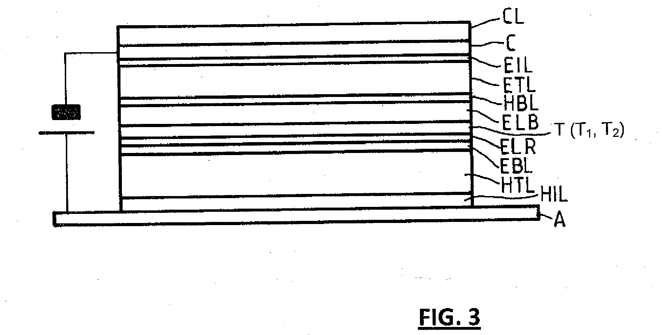

- La figure 3, la structure d'une OLED selon un mode de réalisation de l'invention.

Pour augmenter la durée de vie d'une OLED blanche, ou plus généralement comportant au moins deux couches émettrices dont une bleue, l'invention propose d'insérer, entre lesdites couches émettrices, une couche tampon permettant le transport d'électrons et de trous au moins sur une partie de son épaisseur.

De préférence, l'épaisseur de la couche tampon peut être comprise entre 1 et 10 nm.

Comme illustré sur la figure 2, cette couche tampon T est en fait une bicouche, formée par une première couche élémentaire T₁, conductrice de trous, et une deuxième couche élémentaire T₂ conductrice d'électrons. En particulier, la première couche élémentaire est constituée par la matrice de la couche électroluminescente rouge ELR (plus généralement : à bande interdite étroite), mais sans dopant ; tandis que la deuxième couche élémentaire est constituée par la matrice de la couche électroluminescente bleue ELB, également sans dopant. L'inverse est également possible, au moins en principe, mais il y a peu d'émetteurs bleus conducteurs de trous.

Dans ces conditions, un exciton généré dans une des couches émettrices diffusera beaucoup plus difficilement vers le second émetteur du fait de son éloignement. En outre, on comprend que la zone principale de recombinaison des porteurs se situe à l'interface entre les deux couches élémentaires, c'est-à-dire dans un lieu non émissif et donc sans réelle conséquence sur l'émission si les matériaux de cette zone se dégradent. Il s'agit là d'un avantage considérable par rapport aux réalisations connues de l'art antérieur, comprenant une couche tampon unique.

L'utilisation de la couche tampon permet de limiter tant la diffusion d'excitons que la formation d'ions instables susceptibles de dégrader rapidement l'OLED.

Comme la couche tampon n'est pas une couche de blocage excitonique, la diode de l'invention ne doit pas associer un émetteur fluorescent et un émetteur phosphorescent. Les deux émetteurs séparés par la couche tampon doivent présenter une électroluminescence du même type.

Comme le montre la figure 4 (qui n'est pas à l'échelle), une OLED selon l'invention se présente typiquement sous la forme d'un empilement de couches :
- Une anode A, qui peut être réalisée par exemple en AlCu/TiN, Cr, Mo, W, AlCu/W, AlCu/Mo, Ag, ITO (oxyde d'indium et d'étain) ou en un autre oxyde transparent conducteur.
- Une couche d'injection de trous HIL, optionnelle, qui peut être réalisée, par exemple, en CuPc, Pedot, ou Pani.
- Une couche de transport de trous HTL, éventuellement dopée pour en augmenter la conductivité et faciliter l'injection de porteurs sans devoir utiliser une HIL, par exemple réalisée en SpiroTTB dopé F4TCNQ(1%), ou NPB, TPD, Spiro TAD... Le dopant peut aussi être MoO3.
- Une couche de blocage d'électrons EBL, optionnelle, qui peut être réalisée, par exemple, en NPB, TPD, alpha NPD
- Une première couche électroluminescente ELR (bande interdite étroite), par exemple en NPB (matrice fluorescente assurant le transport de trous) dopé avec du Rubrene (émetteur jaune-vert fluorescent, fournisseur Aldrich). La matrice peut aussi être du TPD ; le dopant peut être aussi RD3 (nom commercial Kodak), YD3 (nom commercial Kodak), DCM, DCM2, Coumarin...
- Une couche tampon T, constituée des matrices de la première et de la deuxième couche électroluminescente, juxtaposées pour former une bicouche.
- Une deuxième couche électroluminescente ELB (bande interdite large), par exemple en BH3 (matrice fluorescente assurant le transport d'électrons) dopé avec du BD3 (émetteur fluorescent bleu profond, fournisseur Kodak). On peut aussi utiliser du DPVBi, SMB13 dopé SEB116 (nom commerciaux Merck), Balq...
- Une couche de blocage de trous HBL, par exemple en Alq3, Balq, TPBi, BCP, Bphen...
- Une couche de transport d'électrons ETL en Bphen ou BCP dopé par du Ca, Cs, Cs₂CO₃...
- Une couche d'injection d'électrons EIL, optionnelle, qui peut être réalisée en LiF (fluorure de lithium).
- Une cathode C en Al, Mg/Ag, Ca, Ca/Ag...
- Une couche CL, optionnelle, permettant d'améliorer l'extraction de lumière à travers la cathode et/ou l'anode (« capping layer ») dans le cas d'une diode à émission par la face supérieure ou transparente. Cette couche peut être, par exemple, en SiO, MoO₃, TeO₂, ITO, SnO₂, Sb₂O₃, ZnSe.

Un exemple concret de réalisation de l'invention est constitué par l'empilement de couches suivant :
- A : AlCu(100nm)/TiN : 10nm
- HTL : SpiroTTB dopé F4TCNQ (1%) : 32nm
- ELB : NPB dopé Rubrene (1%) : 5nm
- T₁: NPB: 5 nm
- T₂: BH3 : 5 nm
- ELR : BH3 dopé BD3 (1,5%) : 12nm
- HBL : Alq3 : 2nm
- ETL : Bphen dopé Ca (4%) : 42nm
- C : Ag : 15nm
- CL : SiO : 25nm.

On constate sur une telle diode une amélioration significative de la durée de vie par rapport à des diodes conventionnelles présentant le même empilement à l'exception des couches tampon. Cette durée de vie, définie comme le temps au bout duquel la luminance est réduite de 50%, est améliorée d'un facteur compris typiquement entre 5 et 10 pour des luminances initiales comprises entre 400 et 1500 Cd/m².

### Glossaire

SpiroTTB : 2,2',7,7'-tetra(N, N-di-tolyl)amino-spiro-bifluorene ;
F4TCNQ :7,7,8,8-Tetracyano-2,3,5,6-tetrafluoroquinodimethane ;
NPB : N,N'-Bis(naphthalen-1-yl)-N,N'-bis(phenyl)benzidine ;
TPD : N,N'-Bis(3-methylphenyl)-N,N'-bis(phenyl)-9,9-dimethyl-fluorene ;
Spiro TAD : (2,2',7,7'-Tetrakis(n,n-diphenylamino)-9,9'-spirobifluorene) ;
DCM: 4-(Dicyanomethylene)-2-methyl-6-(4-dimethylamino styryl)-4H-pyran ;
DCM2 : 4-(Dicyanomethylene)-2-methyl-6-julolidyl-9-enyl-4H-pyran ;
Coumarin : 1-benzopyrane-2-one ;
DPVBi : 4,48-bis (2, 28-diphenylvinyl)-1,18-biphenyl ;
Balq : Bis-(2-methyl-8-quinolinolate)-4(phenylphenolato) aluminium ;
Alq3 : Tris-(8-hydroxyquinoline)aluminum ;
TPBi : 2,2',2"-(1,3,5-Benzinetriyl)-tris(1-phenyl-1-H-benzimidazole) ;
BCP : Bathocuproine ;
Bphen : 4,7-Diphenyl-1,10-phenanthroline ;
Pedot : polyethylenedioxythiophene éventuellement dope Polystyrene sulfonate
Pani: Polyaniline ;
CuPc : Phthalocyanine de Cuivre (C₃₂H₁₆N₈Cu).
Alpha NPD: N, N'-Bis(naphthalen-1-yl)-N,N'-bis(phenyl)-2,2-dimethylbenzidine ;
BH3, BD3 et SMB13 sont des noms commerciaux.

## Revendications

1. Diode électroluminescente organique comprenant au moins deux couches électroluminescentes (ELR, ELB), toutes deux de type fluorescent ou de type phosphorescent, émettant à deux longueurs d'onde différentes et comportant une matrice et un dopant électroluminescent, ainsi qu'une couche tampon (T) conductrice d'électrons et de trous disposée entre lesdites couches électroluminescentes, constituée par une bicouche comportant une couche de transport d'électrons (T₂) et une couche de transport de trous (T₁), lesdites couches de transport d'électrons et de trous étant sans dopant, **caractérisé en ce que** chacune desdites couches de transport d'électrons et de trous comprend une matrice de même composition que celle de la couche électroluminescente la plus proche.

2. Diode électroluminescente organique selon la revendication 1 dans laquelle lesdites couches électroluminescentes comprennent une matrice et un dopant électroluminescent, et dans laquelle ladite couche tampon est uniquement constituée des matériaux des matrices desdites couches électroluminescentes.

3. Diode électroluminescente organique selon l'une des revendications précédentes dans laquelle ladite couche tampon présente une épaisseur totale comprise entre 1 et 10 nm.

4. Diode électroluminescente organique selon l'une des revendications précédentes dans laquelle l'une desdites couches électroluminescentes est adaptée pour émettre une lumière bleue.

5. Diode électroluminescente organique selon la revendication 4, dans laquelle lesdites couches électroluminescentes sont choisies de manière à permettre l'émission de lumière blanche par la diode.

## Patentansprüche

1. Organische Leuchtdiode, umfassend mindestens zwei elektrolumineszente Schichten (ELR, ELB), beide von fluoreszierendem Typ oder von phosphoreszierendem Typ, die zu zwei unterschiedlichen Wellenlängen emittieren und eine Matrix und ein elektrolumineszentes Dotierungsmittel einschließen, ebenso wie eine elektronen- und löcherleitende Pufferschicht (T), die zwischen den elektrolumineszenten Schichten angeordnet ist, aus einer Doppelschicht bestehend, die eine Elektronentransportschicht (T₂) und eine Löchertransportschicht (T₁) einschließt, wobei die Elektronen- und Löchertransportschicht ohne Dotierungsmittel sind, **dadurch gekennzeichnet, dass** jede der Elektronen- und Löchertransportschicht eine Matrix von gleicher Zusammensetzung wie diejenige der nächstgelegenen elektrolumineszenten Schicht umfasst.

2. Organische Leuchtdiode nach Anspruch 1, wobei die elektrolumineszenten Schichten eine Matrix und ein elektrolumineszentes Dotierungsmittel umfassen und wobei die Pufferschicht nur aus den Materialien der Matrizen der elektrolumineszenten Schichten besteht.

3. Organische Leuchtdiode nach einem der vorstehenden Ansprüche, wobei die Pufferschicht eine Gesamtdicke zwischen 1 und 10 nm aufweist.

4. Organische Leuchtdiode nach einem der vorstehenden Ansprüche, wobei die eine der elektrolumineszenten Schichten angepasst ist, um ein blaues Licht zu emittieren.

5. Organische Leuchtdiode nach Anspruch 4, wobei die elektrolumineszenten Schichten so ausgewählt sind, dass die Emission von weißem Licht durch die Diode ermöglicht wird.

## Claims

1. Organic light-emitting diode comprising at least two electroluminescent layers (ELR, ELB), both being of fluorescent type or phosphorescent type, emitting at two different wavelengths and comprising a matrix and an electroluminescent dopant, as well as a hole- and electron-conducting buffer layer (T) arranged between said electroluminescent layers, constituted by a bi-layer comprising an electron-transport layer (T₂) and a hole-transport layer (T₁), said electron- and hole-transport layers being without dopant, **characterised in that** each of said electron- and hole-transport layers comprises a matrix with the same composition as the closest electroluminescent layer.

2. Organic light-emitting diode according to claim 1, wherein said electroluminescent layers comprise a matrix and an electroluminescent dopant, and wherein said buffer layer is made only from the materials of the matrixes of said electroluminescent layers.

3. Organic light-emitting diode according to any one of the preceding claims, wherein said buffer layer has a total thickness ranging from 1 to 10 nm.

4. Organic light-emitting diode according to any one of the preceding claims, wherein one of said electroluminescent layers is adapted to emit a blue light.

5. Organic light-emitting diode according to claim 4, wherein said electroluminescent layers are selected to enable the emission of white light by the diode.
